# EUROPEAN PATENT SPECIFICATION

(11) **EP 2 816 364 B1**
(45) Date of publication and mention of the grant of the patent: **27.09.2023**
(21) Application number: 13003144.6
(22) Date of filing: 20.06.2013
(51) Int. Cl.: G01R 31/327, H02H 7/08

(54) **Proof test arrangement and proof test method for a switchgear**
Wiederholungstestanordnung und Wiederholungstestverfahren für eine Schaltanlage
Dispositif de test d'épreuve et procédé de test d'épreuve pour un dispositif de commutation

(43) Date of publication of application: 24.12.2014
(73) Proprietor: ABB AG, 68309 Mannheim (DE)
(72) Inventor: Hermann, Wolfgang, 69126 Heldelberg (DE); Müller, Klaus-Georg, 69259 Wilhelmsfeld (DE)
(74) Representative: Kesselhut, Wolf

(56) References cited:
- US-A- 5 475 609
- US-A1- 2003 184 931
- US-A1- 2003 184 939
- US-A1- 2008 013 227
- US-A1- 2008 215 278
- US-A1- 2010 060 468
- "KEVCD A, Indoor combined sensor; Indoor current sensor", , 30 April 2011 (2011-04-30), pages 1-8, XP055084794, Retrieved from the Internet: URL:https://library.e.abb.com/public/7830b 8e3a1e04d3bb2ff4eea3eba684e/KEVCD%20A_1VLC 000588%20Rev.1,%20en.pdf [retrieved on 2013-10-22]

## Description

The invention relates to a proof test arrangement and proof test method for a switchgear device or component and in particular a low voltage switchgear device or component, like for example a motor controller or motor control center.

Several known switchgears or switchgear assemblies, like for example MNSiS, are equipped with a motor controller, which motor controller comprises in build safety functions like TOL (thermal overload), for example by applying future PT100, PTC or the like, which are ATEX approved.

One of the key figures for ATEX, whereas the ATEX directive gives a definition of what devices and components according to their specifications are allowed in an environment with an explosive atmosphere, and SIL (Safety Integrity Level) approved devices is the PFD (Probability of Failure on Demand) value. This PFD value indicates the probability that an unknown (random) error has appeared in the device in case the safety function is required. As the PFD value is time depending a test of the safety function in periodical time intervals allows postulating an "as-new-state" of the device when the test is passed successfully.

The industrial standard IEC61508 requires such a proof test. To execute the proof test the respective device is stimulated with an input current value and the reaction, in particular the switching off process/procedure is observed and monitored, wherein the respective device under test is moved to a special test rack and the currents are generated with an external current source, wherein for a current generation in a range within several 100 amps this requires a relatively big current source and a significant cabling effort.

Therefore, it would be desirable that the respective device is tested inside the switchgear, what in deed does not seem to be usually possible because a test current of 6 times nominal motor current is needed to test the TOL (thermal overload) protection function, which presently cannot be provided with/by common arrangements and low voltage switchgears in an efficient and/or secure way.

US 2003184939A1 describes an online method of testing an electric power system relay, that uses digitized real time sensed values of power system currents and voltages to perform specified relay functions. The sensed values for current and voltage are substituted by test values on basis of which a proof test is performed, whereas the sensed values of the current are monitored even while the test values are being used by the logic for performing the proof test.

Therefore, it is one object of the invention to provide an arrangement and a method which allow to perform a more efficient proof test of a device or switchgear component inside a switchgear and in particular inside a low voltage switchgear.

This object is solved by a proof test arrangement according to claim 1, and a method as claimed in claim 7.

Further embodiments and refinements of the arrangement as well as a corresponding method are disclosed in further claims and the following description.

The proof test arrangement according to the invention which is configured to execute and perform a proof test for a switchgear and a switchgear device or component, which switchgear device or component controlls a consumer or consumer load or load, like for example a motor controller or motor control center, comprises at least one data processing unit for providing at least one executable data structure and/or program code means, in particular a tool based wizard, at least one measurement sensor and at least one interface for the transmission of sensor and/or measurement data. The proof test arrangement is configured to support and /or perform the test of the device inside the switchgear without the need to remove the device from the switchgear.

The proof test arrangement is characterized in that the consumer is a motor, that the measurement sensor is a combined measurement sensor, which is provided and equipped to at least measure a current and a voltage of the motor, that the data processing unit is configured to measure the timing, and in that a currently voltage of the motor is used to calculate a stimulating current value for the proof test of a motor control center and/or at least one of a motor control, motor protection and timing control.

In a further embodiment of the invention, the current and/or voltage of a motor are measured by the at least one measurement sensor.

Accordingly if one of the values is measured correctly it can be assumed that the measurement sensor and the corresponding communication path is working correctly. This allows for a replacement of a hard to generate input signal of the data processing unit comprising a measurement value calculation unit, by a more easy to generate one. The replacement is done inside the measurement value calculation unit by deriving and/or determining the stimulation value via a predeterminable calculation factor.

In a further embodiment the derived stimulation value is fed via at least one interface into the device and/or component which are to be tested, in particular a motor control center and/or motor protection and/or motor control of a motor control center of a switchgear and/or a low voltage switchgear, and the reaction of the respective device and/or component, in particular the motor control or motor control center, is observed.

In another embodiment the data processing unit may comprise one or more programmable processors executing a computer program and/or program code means to perform functions of the invention by operating on input data and generating output. Method steps can also be performed by, and units or components of the invention can be implemented as, special purpose logic circuitry or an application specific integrated circuit (ASIC). Processors suitable for the execution of a computer program include, by way of example, both general and special purpose microprocessors, and anyone or more processors of any kind of digital computing device. Generally, a processor will receive instructions and data from a read-only memory or a random access memory or both. The essential elements of a computer are at least one processor for executing instructions and one or more memory devices for storing instructions and data. Generally, a computer will also include, or be operatively coupled to receive data from or transfer data to, or both, one or more mass storage devices for storing data, for example, magnetic, magneto-optical disks, optical disks or solid state disks. Such storage means may also be provisioned on demand and be accessible through the Internet or any other interface or data bus. Information carriers suitable for embodying computer program instructions and data include all forms of non-volatile memory, including by way of example semiconductor memory devices, for example, EPROM, EEPROM, and flash memory devices; magnetic disks, e.g ., internal hard disks or removable disks; magneto-optical disks; and CD-ROM and DVD-ROM disks. The processor and the memory can be supplemented by, or incorporated in special purpose logic circuitry.

In an further embodiment to provide for interaction with a user, the invention can be implemented on a computer having a display device, for example, a cathode ray tube (CRT) or liquid crystal display (LCD) monitor, for displaying information to the user and an input device such as a keyboard, touchscreen or touchpad, a pointing device, for example, a mouse or a trackball, by which the user can provide input to the computer. Other kinds of devices can be used to provide for interaction with a user as well; for example, feedback provided to the user can be any form of sensory feedback, for example, visual feedback, auditory feedback, or tactile feedback; and input from the user can be received in any form, including acoustic, speech, or tactile input. The data processing unit can be implemented in a computing system that includes a back-end component, for example, as a data server, or that includes a middleware component, for example, an application server, or that includes a front-end component, for example, a client computer having a graphical user interface or a Web browser through which a user can interact with an implementation of a data processing unit, or any combination of such back-end, middleware, or front-end components.

In a further embodiment the data processing unit may build a withdrawable part or insertion of a switchgear assembly and/or may be integrated in the switchgear device or component to be tested, in particular the motor control center or motor control.

The proposed proof test according to the invention verifies the whole safety chain from the at least one measurement sensor, data processing unit and/or logic solver, the measurement value calculation unit, the switchgear device or component which has to be tested, in particular a motor control center and/or motor protection and motor control, the timing control, and, if provided, the contactors.

In a further embodiment the currently voltage of a motor is used to calculate a stimulating current value for a proof test of a motor control center and/or at least one of a motor control, motor protection and timing control.

In another embodiment at least one temperature value of the respective switchgear device, in particular a motor control center, is measured and/or determined to generate a stimulation current to perform the proof test for systems and devices without voltage measurement means.

In another embodiment at least one voltage value of the respective device to be tested is measured and/or determined to generate a stimulation temperature to perform the proof test, for example in case of tests for a motor temperature sensor based protection PT100/PTC.

In a further embodiment, a motor can be started already before a proof test, in particular a proof test of the motor control center, is started.

This enables the user to bring the process to a safe state before starting the proof test, e.g. for heavy duty starters.

Furthermore, this enables users to skip special startup phases, e.g. for a Star/Delta, Softstarter.

The proof test according to the invention can or may easily be executed in a test rack with a calibrated voltage source, if desired.

According to another aspect of the invention ,a proof test method for executing and performing a proof test of a switchgear device or component, wherein a proof test for a switchgear or a switchgear device or component and/or a low voltage switchgear device or component, which controls a consumer or consumer load or load, like for example a motor controller or motor control center, is executed and performed, is characterized in that sensor and/or measurement data of the consumer or consumer load or load are acquired by means of a measurement sensor and processed by means of a data processing unit, to support and /or perform the test of the device inside the switchgear without the need to remove the device from the switchgear. According to the method, a stimulation value, in particular a current value, is generated by means of an acquired and/or retrieved and/or existing measurement value of the consumer or consumer load or load, wherein by processing this measurement value a stimulation value is determined for stimulating the respective switchgear device or component with an input value and detecting and monitoring the reaction, in particular the switching off process/procedure, of the device, and wherein both, current and voltage of the consumer or consumer load are measured, and the timing is measured by the observing and/or performing data processing unit.

The method according to the invention may be executed and/or performed by use or means of an arrangement described above.

The terms consumer, consumer load or load are used alternatively in the same content.

In a further embodiment a combined measurement sensor (MU) is provided as a measurement sensor to measure current and/or voltage.

In a further refinement of the method, the current and/or voltage of a motor are measured by the at least one measurement sensor.

Accordingly, if one of the values is measured correctly, it can be assumed that the measurement sensor and the corresponding communication path is working correctly.

This allows for a replacement of a hard to generate input signal of the data processing unit, comprising a measurement value calculation unit, by a more easy to generate one. The replacement is done inside the measurement value calculation unit by deriving and/or determining the stimulation value via a predeterminable calculation factor.

In a further embodiment of the method, the derived stimulation value is fed via at least one interface into the device and/or component which are to be tested, in particular a motor control center and/or motor protection and/or motor control of a motor control center of a switchgear and/or a low voltage switchgear, and the reaction of the respective device and/or component, in particular the motor control or motor control center, is observed.

In another refinement the timing is measured by the observing and/or performing data processing unit.

The proposed proof test method according to the invention verifies the whole safety chain from the at least one measurement sensor, data processing unit and/or logic solver,
the measurement value calculation unit, the switchgear device or component which has to be tested, in particular a motor control center and/or motor protection and motor control, the timing control, and as the case may be or if provided the contactors.

In a further implementation of the method, the currently voltage, in particular of a motor, is used to calculate a stimulating current value for proof test of a motor control center and/or at least one of a motor control, motor protection and timing control.

In another implementation of the method,at least one temperature value of the respective switchgear device, in particular a motor control center, is measured and/or determined to generate a stimulation current to perform the proof test for systems and devices without voltage measurement means.

In another implementation of the method, at least one voltage value of the respective device to be tested is measured and/or determined to generate a stimulation temperature to perform the proof test, for example in case of tests for motor temperature sensor based protection PT100/PTC.

In a further refinement a motor can already be started before a proof test, in particular the proof test of the motor control center, is started.

This enables the user to bring the process to a safe state before starting the proof test, e.g. for heavy duty starters.

Furthermore, this enables users to skip special startup phases, e.g. for Star/Delta, Softstarter.

The proof test according to the invention can or may be executed in a test rack, with a calibrated voltage source, if desired.

The further disclosure and explanation of the invention as well as advantageous embodiments thereof are hereinafter presented with reference to the drawings and several illustrative embodiments.

In the drawings, the figures present:
Fig. 1 an exemplary proof test arrangement and method according to the invention to perform a proof test for a motor control center, and
Fig. 2 an exemplary safety chain according to a proof test arrangement for a motor control.

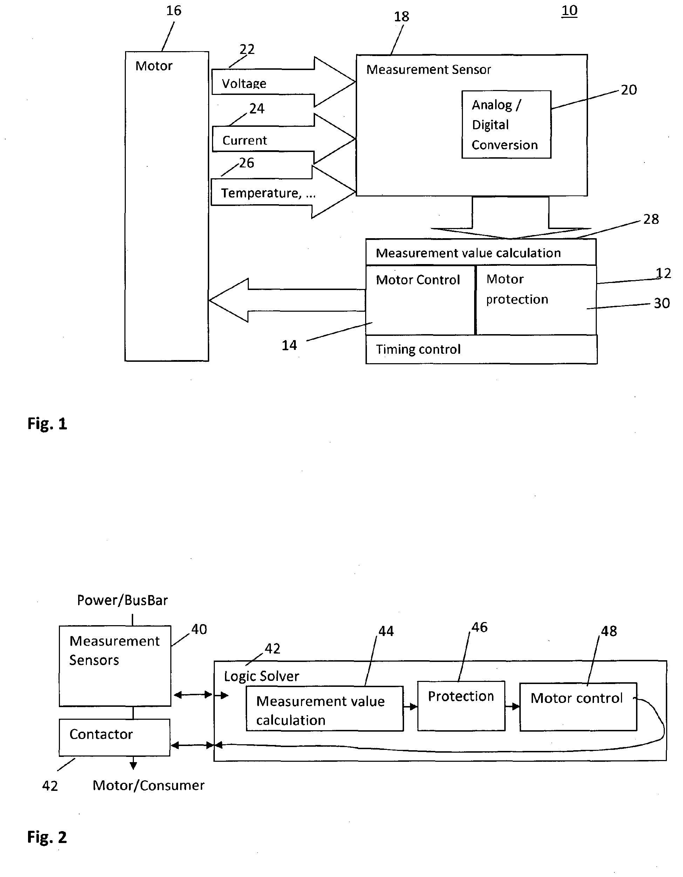

In Fig 1, an exemplary embodiment of a proof test arrangement and method to perform a proof test for a motor control center inside a switchgear, and in particular a low voltage switchgear is disclosed.

The test arrangement 10 according to Fig. 1 executes and performs a proof test for a MCC (motor control center) 12 and/or motor control 14 in a switchgear, in particular a low voltage switchgear. The MCC may be built as a withdrawable part or insertion or drawer for said switchgear and controls a motor 16, in particular for a drive, as a consumer or consumer load or load.

At least one measurement sensor 18 is provided comprising at least one analog digital converter 20 for the measurement and detection of performance data and/or a parameter of the motor, like for example at least one of voltage 22, current 24, temperature 26 and drive or revolution speed.

Furthermore, a data processing unit 28 is provided, which comprises at least one executable data structure and/or program code means, in particular a tool based wizard providing a measurement value calculation, and/or at least one interface for the transmission of sensor and/or measurement data, wherein the processing unit 28 is configured to support and /or perform the test of the device inside the switchgear without the need to remove the device from the switchgear.

In the data processing and in particular the measurement value calculation unit 28, a stimulation value, in particular a current value, is generated by processing an acquired and/or retrieved and/or existing measurement value 22,24,26, in particular a voltage value 22, of the consumer and/or the motor 16. According to this measurement value 22,24,26 a stimulation value is determined for stimulating the respective device, in this example the motor control center or motor control, with an input value and detecting and monitoring the reaction of the device and/or the consumer, in particular the switching off process/procedure, of the device.

For example the MNSiS solution of ABB, which is equipped with a motor controller, which motor controller comprises in build safety functions like TOL (thermal overload), has the advantage that it uses a combined sensor Measurement Sensor (MU) to measure current 22 and voltage 24 derived from the motor 16. Thus, if one of the values 22, 24 can be measured correctly, it can be assumed that the measurement sensor 18 and the communication path is working correctly. This allows and enables a replacement of a hard to generate input signal of the measurement unit by a more easy to generate one. The replacement is done inside the measurement value calculation 28 by deriving the value via a calculation factor. The derived value is fed into the motor protection 30 and motor control 14, and the reaction of the motor control is observed.

The timing is measured by the observing data processing unit, for example a microprocessor and/or microcomputer and/or personal computer (PC) and/or notebook and/or netbook and/or tablet pc, and therefore the proof test verifies the whole safety chain, as disclosed in fig. 2 from Measurement Sensor(s) 40 to Logic solver 42, and in particular measurement value calculation 44 to motor protection 46 and motor control 48 and timing, and to contactors 52.

## Claims

1. Proof test arrangement (10) for executing and performing a proof test for a switchgear or a switchgear device or component (12,14), which switchgear device or component (12, 14) controls a consumer (16) or consumer load, and which comprises at least one data processing unit (28) providing at least one executable data structure and/or program code means, and at least one measurement sensor (18) and at least one interface for the transmission of sensor and/or measurement data, wherein a stimulation value is generated by processing an existing measurement value of the consumer or consumer load acquired by the measurement sensor (18), and wherein by processing said measurement value, the data processing unit (28) is configured to generate and determine a stimulation value for stimulating the respective switchgear device or component with an input value and detect and monitor the reaction of the switchgear device or component,
**characterized in that**
the consumer is a motor (16), that the measurement sensor (18) is a combined measurement sensor, which is provided and equipped to at least measure a current (24) and a voltage (22) of the motor (18), that the data processing unit (28) is configured to measure the timing, and **in that** a currently voltage of the motor (16) is used to calculate a stimulating current value for the proof test of a motor control center and/or at least one of a motor control, motor protection and timing control.

2. Proof test arrangement according to claim 1,
**characterized in that**
the stimulation value is fed via the at least one interface into the switchgear device (12, 14) and/or component which is to be tested, and that the reaction of the respective switchgear device (12, 14) and/or component is monitored and/or observed.

3. Proof test arrangement according to one of the preceding claims,
**characterized in that**
at least one temperature value of the respective switchgear device which is to be tested is measured and/or determined to generate a stimulation current to perform a proof test for systems and devices without voltage measurement means.

4. Proof test arrangement according to one of the preceding claims,
**characterized in that**
at least one voltage value (22) of the respective device to be tested is measured and/or determined to generate a stimulation temperature to perform the proof test.

5. Proof test arrangement according to one of the preceding claims,
**characterized in that**
the motor (16) is already startable before a proof test of a motor control center (12) is started, so as to allow and enable a user to bring the process to a safe state before starting the proof test.

6. Proof test arrangement according to one of the preceding claims,
**characterized in that**
the proof test is executable in a test rack with a calibrated voltage source.

7. Proof test method for executing and performing a proof test for a switchgear or a switchgear device (12, 14) or component and/or a low voltage switchgear device or component, which controls a consumer (16) or consumer load or load, wherein sensor and/or measurement data of the consumer (16) or consumer load or load is acquired by means of a measurement sensor (18) and processed by means of a data processing unit (28), wherein a stimulation value is generated by processing an existing measurement value of the consumer or consumer load or load, wherein by processing this measurement value a stimulation value is determined for stimulating the respective switchgear device (12, 14) or component with an input value and detecting and monitoring the reaction of the device, and wherein both current (24) and voltage (22) of the consumer or consumer load are measured,
**characterized in that**
a combined measurement sensor is used which is provided and equipped to at least measure a current (24) and a voltage (22) of a motor (16), that the timing is measured by the data processing unit (28), and **in that** a currently voltage of the motor is used to calculate a stimulation current value for a proof test of a motor control center and/or at least one of a motor control, motor protection and timing control.

8. Proof test method according to claim 7,
**characterized in that**
the stimulation value is fed via at least one interface into the switchgear device (12, 14) and/or component which is to be tested, and that the reaction of the respective switchgear device(12, 14) and/or component is monitored and/or observed.

9. Proof test method according to one of the preceding claims 7 to 8,
**characterized in that**
at least one temperature value of the respective switchgear device (12, 14) which is to be tested is measured and/or determined to generate a stimulation current to perform the proof test for systems and devices without voltage measurement means.

10. Proof test method according to one of the preceding claims 7 to 9,
**characterized in that**
at least one voltage value of the respective device to be tested is measured and/or determined to generate a stimulation temperature to perform the proof test.

11. Proof test method according to one of the preceding claims 7 to 10,
**characterized in that**
the motor (16) is already startable before a proof test of the motor control center is started, so as to allow and enable a user to bring the process to a safe state before starting the proof test.

12. Proof test method according to one of the preceding claims 7 to 11,
**characterized in that**
the proof test is executable in a test rack with a calibrated voltage source.

13. Switchgear comprising a proof test arrangement according to one of the claims 1 to 6.

## Patentansprüche

1. Prüftestanordnung (10) zum Ausführen und Durchführen eines Prüftests für eine Schaltanlage oder eine Schaltanlagenvorrichtung oder -komponente (12, 14), wobei die Schaltanlagenvorrichtung oder -komponente (12, 14) einen Verbraucher (16) oder eine Verbraucherlast steuert, die mindestens eine Datenverarbeitungseinheit (28), die mindestens eine ausführbare Datenstruktur und/oder Programmcodemittel bereitstellt, und mindestens einen Messsensor (18) und mindestens eine Schnittstelle für die Übertragung von Sensor- und/oder Messdaten umfasst, wobei durch Verarbeiten eines bestehenden Messwertes des Verbrauchers oder der Verbraucherlast, der durch den Messsensor (18) erfasst wird, ein Stimulationswert erzeugt wird und wobei durch Verarbeiten des Messwertes die Datenverarbeitungseinheit (28) dazu ausgelegt ist, einen Stimulationswert zum Stimulieren der jeweiligen Schaltanlagenvorrichtung oder -komponente mit einem Eingangswert zu erzeugen und zu bestimmen und die Reaktion der Schaltanlagenvorrichtung oder -komponente zu detektieren und zu überwachen, **dadurch gekennzeichnet, dass**
der Verbraucher ein Motor (16) ist, dass der Messsensor (18) ein kombinierter Messsensor ist, der bereitgestellt und ausgerüstet ist, um mindestens einen Strom (24) und eine Spannung (22) des Motors (18) zu messen, dass die Datenverarbeitungseinheit (28) dazu ausgelegt ist, das Timing zu messen, und dadurch, dass eine derzeitige Spannung des Motors (16) verwendet wird, um für den Prüftest eines Motorsteuerzentrums und/oder mindestens eines von einer Motorsteuerung, einem Motorschutz und einer Timingsteuerung einen Stimulationsstromwert zu berechnen.

2. Prüftestanordnung nach Anspruch 1,
**dadurch gekennzeichnet, dass**
der Stimulationswert via die mindestens eine Schnittstelle in die zu testende Schaltanlagenvorrichtung (12, 14) und/oder -komponente eingespeist wird und dass die Reaktion der jeweiligen Schaltanlagenvorrichtung (12, 14) und/oder - komponente überwacht und/oder beobachtet wird.

3. Prüftestanordnung nach einem der vorhergehenden Ansprüche,
**dadurch gekennzeichnet, dass**
mindestens ein Temperaturwert der jeweiligen zu testenden Schaltanlagenvorrichtung gemessen und/oder bestimmt wird, um einen Stimulationsstrom zu erzeugen, um einen Prüftest für Systeme und Vorrichtungen ohne Spannungsmessmittel durchzuführen.

4. Prüftestanordnung nach einem der vorhergehenden Ansprüche,
**dadurch gekennzeichnet, dass**
mindestens ein Spannungswert (22) der jeweiligen zu testenden Vorrichtung gemessen und/oder bestimmt wird, um eine Stimulationstemperatur zu erzeugen, um den Prüftest durchzuführen.

5. Prüftestanordnung nach einem der vorhergehenden Ansprüche,
**dadurch gekennzeichnet, dass**
der Motor (16) bereits startbar ist, bevor ein Prüftest eines Motorsteuerzentrums (12) gestartet wird, um es einem Benutzer zu erlauben und zu ermöglichen, den Prozess vor Starten des Prüftests in einen sicheren Zustand zu bringen.

6. Prüftestanordnung nach einem der vorhergehenden Ansprüche,
**dadurch gekennzeichnet, dass**
der Prüftest in einem Testgestell mit einer kalibrierten Spannungsquelle ausführbar ist.

7. Prüftestverfahren zum Ausführen und Durchführen eines Prüftests für eine Schaltanlage oder eine Schaltanlagenvorrichtung (12, 14) oder -komponente und/oder eine Niederspannungsschaltanlagenvorrichtung oder -komponente, die einen Verbraucher (16) oder eine Verbraucherlast oder Last steuert, wobei Sensor- und/oder Messdaten des Verbrauchers (16) oder der Verbraucherlast oder Last mittels eines Messsensors (18) erfasst und mittels einer Datenverarbeitungseinheit (28) verarbeitet werden, wobei durch Verarbeiten eines bestehenden Messwertes des Verbrauchers oder der Verbraucherlast oder Last ein Stimulationswert erzeugt wird, wobei durch Verarbeiten dieses Messwertes ein Stimulationswert zum Stimulieren der jeweiligen Schaltanlagenvorrichtung (12, 14) oder -komponente mit einem Eingangswert und Detektieren und Überwachen der Reaktion der Vorrichtung bestimmt wird und wobei sowohl ein Strom (24) als auch eine Spannung (22) des Verbrauchers oder der Verbraucherlast gemessen werden,
**dadurch gekennzeichnet, dass**
ein kombinierter Messsensor verwendet wird, der bereitgestellt und ausgerüstet ist, um mindestens einen Strom (24) und eine Spannung (22) eines Motors (16) zu messen, dass das Timing von der Datenverarbeitungseinheit (28) gemessen wird und dadurch, dass eine derzeitige Spannung des Motors verwendet wird, um für einen Prüftest eines Motorsteuerzentrums und/oder mindestens eines von einer Motorsteuerung, einem Motorschutz und einer Timingsteuerung einen Stimulationsstromwert zu berechnen.

8. Prüftestverfahren nach Anspruch 7,
**dadurch gekennzeichnet, dass**
der Stimulationswert via mindestens eine Schnittstelle in die zu testende Schaltanlagenvorrichtung (12, 14) und/oder -komponente eingespeist wird und dass die Reaktion der jeweiligen Schaltanlagenvorrichtung (12, 14) und/oder - komponente überwacht und/oder beobachtet wird.

9. Prüftestverfahren nach einem der vorhergehenden Ansprüche 7 bis 8,
**dadurch gekennzeichnet, dass**
mindestens ein Temperaturwert der jeweiligen zu testenden Schaltanlagenvorrichtung (12, 14) gemessen und/oder bestimmt wird, um einen Stimulationsstrom zu erzeugen, um den Prüftest für Systeme und Vorrichtungen ohne Spannungsmessmittel durchzuführen.

10. Prüftestverfahren nach einem der vorhergehenden Ansprüche 7 bis 9,
**dadurch gekennzeichnet, dass**
mindestens ein Spannungswert der jeweiligen zu testenden Vorrichtung gemessen und/oder bestimmt wird, um eine Stimulationstemperatur zu erzeugen, um den Prüftest durchzuführen.

11. Prüftestverfahren nach einem der vorhergehenden Ansprüche 7 bis 10,
**dadurch gekennzeichnet, dass**
der Motor (16) bereits startbar ist, bevor ein Prüftest des Motorsteuerzentrums gestartet wird, um es einem Benutzer zu erlauben und zu ermöglichen, den Prozess vor Starten des Prüftests in einen sicheren Zustand zu bringen.

12. Prüftestverfahren nach einem der vorhergehenden Ansprüche 7 bis 11,
**dadurch gekennzeichnet, dass**
der Prüftest in einem Testgestell mit einer kalibrierten Spannungsquelle ausführbar ist.

13. Schaltanlage, die eine Prüftestanordnung nach einem der Ansprüche 1 bis 6 umfasst.

## Revendications

1. Agencement d'essai d'épreuve (10) pour exécuter et réaliser un essai d'épreuve pour un appareillage de commutation ou un dispositif ou composant d'appareillage de commutation (12, 14), lequel dispositif ou composant d'appareillage de commutation (12, 14) commande un consommateur (16) ou une charge consommatrice, et qui comprend au moins une unité de traitement de données (28) fournissant au moins une structure exécutable de données et/ou un moyen code de programme, et au moins un capteur de mesure (18) et au moins une interface pour la transmission de données de capteur et/ou de mesure, dans lequel une valeur de stimulation est générée en traitant une valeur de mesure existante du consommateur ou de la charge consommatrice acquise par le capteur de mesure (18), et dans lequel, en traitant ladite valeur de mesure, l'unité de traitement de données (28) est configurée pour générer et déterminer une valeur de stimulation pour stimuler le dispositif ou composant d'appareillage de commutation respectif avec une valeur d'entrée et détecter et surveiller la réaction du dispositif ou composant d'appareillage de commutation,
**caractérisé en ce que**
le consommateur est un moteur (16), que le capteur de mesure (18) est un capteur de mesure combiné, qui est prévu et équipé pour au moins mesurer un courant (24) et une tension (22) du moteur (18), que l'unité de traitement de données (28) est configurée pour mesurer la synchronisation, et **en ce qu'**une tension actuelle du moteur (16) est utilisée pour calculer une valeur de courant de stimulation pour l'essai d'épreuve d'un centre de commande de moteur et/ou d'au moins une parmi une commande de moteur, une protection de moteur et une commande de synchronisation.

2. Agencement d'essai d'épreuve selon la revendication 1, **caractérisé en ce que**
la valeur de stimulation est entrée, par l'intermédiaire de l'au moins une interface, dans le dispositif (12, 14) et/ou composant d'appareillage de commutation qui doit faire l'objet d'un essai, et que la réaction du dispositif (12, 14) et/ou composant d'appareillage de commutation respectif est surveillée et/ou observée.

3. Agencement d'essai d'épreuve selon une des revendications précédentes, **caractérisé en ce que**
au moins une valeur de température du dispositif d'appareillage de commutation respectif qui doit faire l'objet d'un essai est mesurée et/ou déterminée pour générer un courant de stimulation pour réaliser un essai d'épreuve pour des systèmes et des dispositifs sans moyen de mesure de tension.

4. Agencement d'essai d'épreuve selon une des revendications précédentes, **caractérisé en ce que**
au moins une valeur de tension (22) du dispositif respectif devant faire l'objet d'un essai est mesurée et/ou déterminée pour générer une température de stimulation pour réaliser l'essai d'épreuve.

5. Agencement d'essai d'épreuve selon une des revendications précédentes, **caractérisé en ce que**
le moteur (16) est déjà démarrable avant qu'un essai d'épreuve d'un centre de commande de moteur (12) soit commencé, afin d'autoriser et de permettre à un utilisateur de mettre le processus dans un état sûr avant de commencer l'essai d'épreuve.

6. Agencement d'essai d'épreuve selon une des revendications précédentes, **caractérisé en ce que**
l'essai d'épreuve est exécutable dans un bâti d'essai avec une source de tension calibrée.

7. Essai d'épreuve procédé pour exécuter et réaliser un essai d'épreuve pour un appareillage de commutation ou un dispositif (12, 14) ou composant d'appareillage de commutation et/ou un dispositif ou composant d'appareillage de commutation à basse tension, qui commande un consommateur (16) ou une charge consommatrice ou une charge, dans lequel des données de capteur et/ou de mesure du consommateur (16) ou de la charge consommatrice ou de la charge sont acquises au moyen d'un capteur de mesure (18) et traitées au moyen d'une unité de traitement de données (28), dans lequel une valeur de stimulation est générée en traitant une valeur de mesure existante du consommateur ou de la charge consommatrice ou de la charge, dans lequel, en traitant cette valeur de mesure, une valeur de stimulation est déterminée pour stimuler le dispositif (12, 14) ou composant d'appareillage de commutation respectif avec une valeur d'entrée et détecter et surveiller la réaction du dispositif, et dans lequel un courant (24) et une tension (22) du consommateur ou de la charge consommatrice sont tous les deux mesurés,
**caractérisé en ce que**
un capteur de mesure combiné est utilisé qui est prévu et équipé pour au moins mesurer un courant (24) et une tension (22) d'un moteur (16), que la synchronisation est mesurée par l'unité de traitement de données (28), et **en ce qu'**une tension actuelle du moteur est utilisée pour calculer une valeur de courant de stimulation pour un essai d'épreuve d'un centre de commande de moteur et/ou au moins une parmi une commande de moteur, une protection de moteur et une commande de synchronisation.

8. Essai d'épreuve procédé selon la revendication 7, **caractérisé en ce que**
la valeur de stimulation est entrée, par l'intermédiaire d'au moins une interface, dans le dispositif (12, 14) et/ou composant d'appareillage de commutation qui doit faire l'objet d'un essai, et que la réaction du dispositif (12, 14) et/ou composant d'appareillage de commutation respectif est surveillée et/ou observée.

9. Essai d'épreuve procédé selon une des revendications précédentes 7 à 8, **caractérisé en ce que**
au moins une valeur de température du dispositif d'appareillage de commutation respectif (12, 14) qui doit faire l'objet d'un essai est mesurée et/ou déterminée pour générer un courant de stimulation pour réaliser l'essai d'épreuve pour des systèmes et des dispositifs sans moyen de mesure de tension.

10. Essai d'épreuve procédé selon une des revendications précédentes 7 à 9, **caractérisé en ce que**
au moins une valeur de tension du dispositif respectif devant faire l'objet d'un essai est mesurée et/ou déterminée pour générer une température de stimulation pour réaliser l'essai d'épreuve.

11. Essai d'épreuve procédé selon une des revendications précédentes 7 à 10, **caractérisé en ce que**
le moteur (16) est déjà démarrable avant qu'un essai d'épreuve du centre de commande de moteur soit commencé, afin d'autoriser et de permettre à un utilisateur de mettre le processus dans un état sûr avant de commencer l'essai d'épreuve.

12. Essai d'épreuve procédé selon une des revendications précédentes 7 à 11, **caractérisé en ce que**
l'essai d'épreuve est exécutable dans un bâti d'essai avec une source de tension calibrée.

13. Appareillage de commutation, comprenant un agencement d'essai d'épreuve selon l'une des revendications 1 à 6.
